# EUROPÄISCHE PATENTSCHRIFT

(11) **EP 3 245 737 B1**
(45) Veröffentlichungstag und Bekanntmachung des Hinweises auf die Patenterteilung: **15.05.2019**
(21) Anmeldenummer: 16700822.6
(22) Anmeldetag: 15.01.2016
(51) Int. Cl.: H03K 19/003

(54) **ELEKTRISCHER SCHALTKREIS MIT STRAHLUNGSSCHUTZ UND BETRIEBSVERFAHREN**
RADIATION HARDENED ELECTRONIC CIRCUIT AND METHOD
CIRCUIT ÉLECTRIQUE AVEC PROTECTION DE RAYONNEMENT ET PROCÉDÉ ASSOCIÉ

(30) Priorität: 15.01.2015 DE 102015200576
(43) Veröffentlichungstag der Anmeldung: 22.11.2017
(73) Patentinhaber: IHP GmbH-Innovations for High Performance Microelectronics / Leibniz-Institut für innovative Mikroelektronik, 15236 Frankfurt / Oder (DE)
(72) Erfinder: SCHOOF, Gunter, 15236 Frankfurt (Oder) (DE)
(74) Vertreter: Eisenführ Speiser
(86) Internationale Anmeldenummer: PCT/EP2016/050818
(87) Internationale Veröffentlichungsnummer: WO 2016/113412

(56) Entgegenhaltungen:
- EP-B1- 1 998 448
- US-A- 6 104 211
- US-A1- 2002 074 609

## Beschreibung

Die vorliegende Erfindung betrifft einen elektrischer Schaltkreis, insbesondere einen integrierten Schaltkreis mit Strahlungsschutz und ein Betriebsverfahren zum Betreiben eines elektrischer Schaltkreises.

Bei integrierten Schaltungen sind sogenannte Single-Event-Effekte (SEE) bekannt, welche durch energiereiche Strahlung, wie z.B. Protonen oder schwere Ionen, ausgelöst werden. Eine derartige Strahlung tritt unter anderem im Weltraum, in Kernreaktoren oder Teilchenbeschleunigern auf. Bei den Single-Event-Effekten kann es insbesondere zum ungewünschten Umschalten eines gespeicherten Bitzustandes kommen, was als Single-Event-Upset (SEU) bekannt ist. Ebenfalls als SEE bekannt sind Single Event Transients (SET), die während einer aktiven Taktflanke am Eingang eines Speicherelementes auftreten können und dann ebenfalls einen fehlerhaften Speicherzustand verursachen. SETs können wie direkte SEUs zu fehlerhaften Speicherzuständen führen.

SEEs weisen im Bezug auf die Taktfrequenz integrierter Schaltungen eine deutlich höhere Zeitkonstante auf und werden daher zeitlich als einzelne und nicht etwa als gleichzeitig mehrfach auftretende Ereignisse betrachtet. Um die vorgenannten Fehler bzw. auf den genannten Effekten basierenden Fehlfunktionen zu verhindern, werden bei herkömmlichen Schaltungen bestimmte, redundante Schaltungsdesigns bevorzugt eingesetzt. Ein typischer Vertreter ist das Triple-Module-Redundancy (TMR)-Design.

Um den Flächenbedarf einer im TMR-Design realisierten integrierten Schaltung zu reduzieren, wurden verbesserte Schaltungsdesigns im Double-Module-Redundancy (DMR)-Design entwickelt, die beispielsweise im Europaischen Patent EP 1 998 448 B1 offenbart sind. Ein weiteres verbessertes Schaltungsdesign ist aus dem Europaischen Patent EP 2 097 980 B1 bekannt.

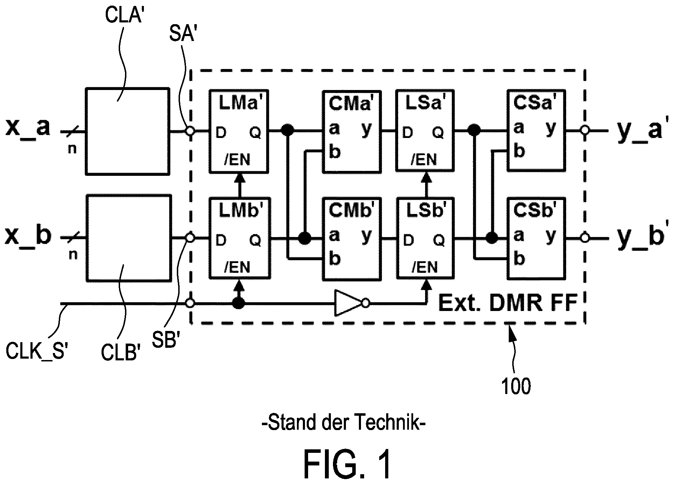

Schoof et. al. haben auf dem 26. ITG/GI/GMM-Workshop "Testmethoden und Zuverlässigkeit von Schaltungen und Systemen" am 24. Februar 2014 einen elektrischen Schaltkreis vorgestellt (siehe Fig. 1), mit zwei redundanten Master-Slave-Speichern, die jeweils ein Master-Speicherelement und ein Slave-Speicherelement aufweisen, einem Signaleingang, der mit einem Eingang eines ersten der Master-Speicherelemente verbunden und zum Anschluss an eine kombinatorische Logikschaltung (Vorschaltlogik) bestimmt ist, zwei Ausgangsauswahlelementen, die eingangsseitig jeweils mit einem Ausgang der Slave-Speicherelemente verbunden sind, zwei Zwischenauswahlelementen, die eingangsseitig jeweils mit einem Ausgang beider Master-Speicherelemente und ausgangsseitig mit verschiedenen der Slave-Speicherelemente verbunden sind. Jeder der zwei Master-Slave-Speicher wird durch eine eigene kombinatorische Vorschaltlogik betrieben. Mittels dieses elektrischen Schaltkreises kann bezüglich herkömmlicher im TMR-Design realisierter integrierter Schaltungen bereits ein nicht unbedeutender Prozentsatz des Hardware-Aufwands eingespart werden.

US 2002/074609 A1 beschreibt eine intergierte Halbleiterschaltung, welche eine durch α-Strahlung erzeugte Fehlfunktion von Flip-Flop Schaltungen verhindert. Dies wird durch eine entsprechende Datenhalteschaltung mit wenigstens drei Flip-Flop Schaltungen ermöglicht. Eine Majoritätslogikschaltung gibt hierbei ein einem Logikwert entsprechendes Signal aus, wobei sich der Logikwert aus der Mehrheit der Ausgaben der wenigstens drei Flip-Flop Schaltungen ergibt.

Es ist eine Aufgabe der vorliegenden Erfindung, einen elektrischen Schaltkreis mit guter Schutzwirkung gegenüber Single-Event-Effekten bereitzustellen, der mit einem reduzierten Hardware-Aufwand hinsichtlich der kombinatorischen Logikschaltung betreibbar ist. Es ist ebenfalls Aufgabe der vorliegenden Erfindung ein verbessertes Betriebsverfahren zum Betreiben eines elektrischen Schaltkreises bereitzustellen.

Gemäß eines ersten Aspekts der vorliegenden Erfindung wird die Aufgabe bezüglich des Schaltkreises gelost durch einen elektrischen Schaltkreis mit zwei redundanten Master-Slave-Speichern, die jeweils ein Master-Speicherelement und ein Slave-Speicherelement aufweisen, einem Signaleingang, der mit einem Eingang eines ersten der Master-Speicherelemente verbunden und zum Anschluss an eine kombinatorische Logikschaltung bestimmt ist, wenigstens einem Ausgangsauswahlelement, das eingangsseitig jeweils mit einem Ausgang der Slave-Speicherelemente verbunden ist, zwei Zwischenauswahlelementen, die eingangsseitig jeweils mit einem Ausgang beider Master-Speicherelemente und ausgangsseitig mit verschiedenen der Slave-Speicherelemente verbunden sind, wobei der elektrische Schaltkreis einen Multiplexer und ein Eingangsspeicherelement aufweist, die eingangsseitig mit dem Signaleingang verbunden sind; der Multiplexer eingangsseitig mit einem Ausgang des Eingangsspeicherelements und ausgangsseitig mit einem Eingang eines zweiten der Master-Speicherelemente verbunden ist; den Master-Slave-Speichern und dem Eingangsspeicherelement ein Speichertaktsignal mit einer gemeinsamen Speichertaktfrequenz zuführbar ist; und dem Multiplexer ein Umschalttaktsignal mit einer Umschalttaktfrequenz zum eingangsseitigen Umschalten des Multiplexers zuführbar ist.

Die Erfindung schließt die Erkenntnis ein, dass der Hardware-Aufwand von vorbekannten elektrischen Schaltkreisen mit Strahlungsschutz bei gleicher Schutzwirkung reduziert werden kann, in dem Hardware-Redundanz (insbesondere die der kombinatorischen Logikschaltung) durch zeitliche Redundanz ersetzt wird. Die Erfindung schließt ebenfalls die Erkenntnis ein, dass es dabei Ziel sein muss, aus dem Ausgangssignal der kombinatorischen Logikschaltung zwei Eingangssignale für das DMR-Speicherelement zu generieren und bei Störungen eines dieser Signale als das richtige für die Weiterverarbeitung herauszufinden. Erfindungsgemäß wird der elektrische Schaltkreis mit Strahlungsschutz im DMR-Design bereitgestellt, wobei er durch lediglich eine kombinatorische Logikschaltung betreibbar ist.

In einer bevorzugten Ausgestaltung sind die Speicherelemente D-Latches. Die Speicherelemente können aus D-Latches bestehende D-Flipflops sein. Das Ausgangsauswahlelement und/oder die Zwischenauswahlelemente können Muller-C-Elemente, insbesondere mit Level-Keeper (Ausgangswerthalteelement) sein, die insbesondere bei ungleichen Eingangssignalen ihren vorherigen Ausgangswert halten. Bevorzugt ist das Ausgangsauswahlelement und/oder sind die Zwischenauswahlelemente als sogenannte Voter-Schaltung (Majority Funktion) ausgebildet, deren Ausgangssignal einer Mehrheit seiner ungeraden Anzahl von Eingangssignalen entspricht. Bei einer DMR (oder einer anderen geradzahligen Redundanz) kann der Ausgang eines Auswahlelements auf einen seiner Eingänge zurückgeführt sein, um eine ungerade Anzahl von Eingangssignalen am Auswahlelement zu erhalten. Bevorzugt ist das Ausgangsauswahlelement und/oder sind die Zwischenauswahlelemente derart ausgebildet, dass bei ungleichen Eingangssignalen der zeitlich vorherige Ausgangswert gehalten wird. Es können zwei Ausgangsauswahlelemente vorgesehen sein, die eingangsseitig jeweils mit einem Ausgang der Slave-Speicherelemente verbunden sind.

Besonders bevorzugt ist der Schaltkreis auf eine Umschalttaktfrequenz mit einer Periodenlänge ausgelegt, die wenigstens zwei Mal so lang ist wie eine angenommene maximale Störimpulsdauer, die zu einem Soft-Error führen kann. Eine angenommene maximale Störimpulsdauer kann beispielsweise 1ns, 1.25ns, 2ns usw. betragen. Bevorzugt ist die Umschalttaktfrequenz dabei doppelt so hoch wie die Speichertaktfrequenz.

Das Speichertaktsignal und/oder das Umschalttaktsignal können über separate Takteingänge in den elektrischen Schaltkreis geführt sein. Besonders bevorzugt ist der Schaltkreis zeitgliedfrei ausgebildet, d.h. insbesondere ohne feste Zeitglieder. Dies hat den Vorteil, dass der elektrische Schaltkreis besonders flexibel einsetzbar und insbesondere technologieunabhängig bleiben kann.

Der Schaltkreis kann eine kombinatorische Logikschaltung aufweisen, die mit dem Signaleingang verbunden ist. Besonders bevorzugt ist der Schaltkreis bezüglich der kombinatorischen Logikschaltung redundanzfrei ausgebildet. Insbesondere kann pro Schaltkreis genau eine kombinatorische Logikschaltung vorgesehen sein.

Der Schaltkreis kann Teil eines integrierten Bauelements sein, bevorzugt als sich n-fach wiederholender Schaltkreis eines integrierten Bauelements, wie beispielsweise eines Chips. Der elektrische Schaltkreis kann beispielsweise auch in Form eines System-in-Package (SIP) oder als Bestandteil eines SIP oder anderer Formen von Mehrfach-Chipanordnungen realisiert sein.

Bevorzugt ist der elektrische Schaltkreis dazu bestimmt einen SET, insbesondere höchstens einen SET pro Taktperiode, insbesondere pro redundantem Speicherelement zu korrigieren. Weiter bevorzugt ist der elektrische Schaltkreis dazu bestimmt, einen SET zu korrigieren, dessen maximale Störimpulsdauer kleiner als eine halbe Periodenlänge der Auslegungs-Umschalttaktfrequenz und/oder der angelegten Umschalttaktfrequenz des elektrischen Schaltkreises ist. Bevorzugt ist die Umschalttaktfrequenz dabei doppelt so hoch wie die Speichertaktfrequenz.

Gemäß eines zweiten Aspekts der vorliegenden Erfindung wird die Aufgabe bezüglich des Schaltkreises gelöst durch einen elektrischen Schaltkreis mit zwei redundanten Speichern, die jeweils ein Master-Speicherelement aufweisen, einem Signaleingang, der mit einem Eingang eines ersten der Master-Speicherelemente verbunden und zum Anschluss an eine kombinatorische Logikschaltung bestimmt ist, einem Ausgangsauswahlelement, das eingangsseitig jeweils mit einem Ausgang der Master-Speicherelemente verbunden ist, wobei der elektrische Schaltkreis einen Multiplexer und ein Eingangsspeicherelement aufweist, die eingangsseitig mit dem Signaleingang verbunden sind; der Multiplexer eingangsseitig mit einem Ausgang des Eingangsspeicherelements und ausgangsseitig mit einem Eingang eines zweiten der Master-Speicherelemente verbunden ist; den Speichern und dem Eingangsspeicherelement ein Speichertaktsignal mit einer gemeinsamen Speichertaktfrequenz zuführbar ist; und dem Multiplexer ein Umschalttaktsignal mit einer Umschalttaktfrequenz zum eingangsseitigen Umschalten des Multiplexers zuführbar ist.

Der Schaltkreis kann entsprechend der mit Bezug auf den ersten Aspekt beschriebenen Ausführungsbeispiele weitergebildet sein, bevorzugt mit dem Unterschied, dass keine Slave-Speicherelemente und bevorzugt keine Zwischenauswahlelemente vorgesehen sind. Bevorzugt sind die Speicherelemente D-Latches. Bezüglich des zweiten Aspekts soll das Merkmal Master-Speicherelement nicht die zwingende Verwirklichung eines Slave-Speicherelements implizieren.

Gemäß eines dritten Aspekts der vorliegenden Erfindung wird die Aufgabe bezüglich des Betriebsverfahrens gelöst durch ein Betriebsverfahren zum Betreiben eines vorbeschriebenen elektrischen Schaltkreises gelöst, wobei das Betriebsverfahren einen Fehlerkorrekturmodus zur Soft-Error-Korrektur aufweist mit den Schritten:
- Ansteuern der Master-Slave-Speicher und des Eingangsspeicherelements mit einer gemeinsamen Speichertaktfrequenz oder Ansteuern der Speicher und des Eingangsspeicherelements mit einer gemeinsamen Speichertaktfrequenz
- Ansteuern des Multiplexers mit einer Umschalttaktfrequenz, wobei
die Umschalttaktfrequenz höher als die gemeinsame Speichertaktfrequenz ist.

In einer bevorzugten Ausgestaltung ist die Umschalttaktfrequenz ein ganzzahliges Vielfaches der Speichertaktfrequenz. Die Umschalttaktfrequenz kann doppelt so hoch wie die Speichertaktfrequenz sein. Eine beispielhafte Umschalttaktfrequenz kann 400 MHz, eine beispielhafte Speichertaktfrequenz im Fehlerkorrekturmodus kann 200 MHz betragen. Wenn der elektrische Schaltkreis in Gänze beispielsweise auf eine Taktfrequenz von 400 MHz ausgelegt ist, so wird diese Frequenz-Auslegung beim Betrieb des Schaltkreises mit der Umschalttaktfrequenz von 400 MHz voll ausgereizt, wohingegen eine bevorzugte Speichertaktfrequenz im Fehlerkorrekturmodus von 200 MHz die Frequenz-Auslegung des elektrischen Schaltkreises nur zur Hälfte ausnutzt. Bevorzugt sind die Speichertaktfrequenz und Umschalttaktfrequenz phasensynchronisiert. Bevorzugt sind das Speichertaktsignal und/oder das Umschalttaktsignal im Wesentlichen Rechtecksignale.

Es hat sich als besonders vorteilhaft herausgestellt, wenn die Umschalttaktfrequenz eine Periodenlänge aufweist, die wenigstens zwei Mal so lang ist wie eine angenommene maximale Störimpulsdauer, die zu einem Soft-Error führen kann.

Besonders bevorzugt weist das Betriebsverfahren einen Fehlerkorrektur-Abschaltmodus auf, bei dem die Umschalttaktfrequenz null ist und insbesondere das Umschalttaktsignal auf statischem High-Pegel liegt und/oder der Signaleingang mittels des Multiplexers auf den Eingang des zweiten der Master-Speicherelemente durchgeschaltet ist. Die gemeinsame Speichertaktfrequenz kann innerhalb des Fehlerkorrektur-Abschaltmodus' doppelt so hoch sein wie außerhalb.

Die Ausführungsbeispiele der vorliegenden Erfindung werden im Folgenden beispielhaft unter Bezugnahme auf die beigefügten Figuren erläutert. Es zeigt:
- Fig. 1: eine vereinfachte Darstellung eines elektrischen Schaltkreises gemäß dem Stand der Technik,
- Fig. 2: eine vereinfachte Darstellung eines ersten Ausführungsbeispiels eines erfindungsgemäßen elektrischen Schaltkreises des ersten Aspekts der Erfindung,
- Fig. 3: eine vereinfachte Darstellung eines ersten Ausführungsbeispiels eines erfindungsgemäßen Betriebsverfahrens des dritten Aspekts der Erfindung,
- Fig. 4: eine vereinfachte Darstellung eines Taktdiagramms im Rahmen des erfindungsgemäßen Betriebsverfahrens,
- Fig. 5: eine vereinfachte Darstellung eines erfindungsgemäßen elektrischen Schaltkreises zur Verdeutlichung des Betriebsverfahrens, und
- Fig. 6: eine vereinfachte Darstellung eines ersten Ausführungsbeispiels eines erfindungsgemäßen elektrischen Schaltkreises des zweiten Aspekts der Erfindung.

Ein elektrischer Schaltkreises 100' (im vorliegenden Beispiel durch ein mit gestrichelten Linien ausgeführtes Rechteck umrandet) gemäß des Standes der Technik in Fig. 1 weist zwei redundante Master-Slave-Speicher LMa', LSa', LMb', LSb' auf. Die redundanten Master-Slave-Speicher LMa', LSa', LMb', LSb' weisen jeweils ein Master-Speicherelement LMa', LMb' und ein Slave-Speicherelement LSa', LSb' auf. Der elektrische Schaltkreis 100' weist einen ersten Signaleingang SA' auf, der mit einem Eingang des ersten Master-Speicherelements LMa' verbunden und zum Anschluss an eine erste kombinatorische Logikschaltung CLA' bestimmt und vorliegend auch an selbige angeschlossen ist. Der elektrische Schaltkreises 100' weist einen zweiten Signaleingang SB' auf, der mit einem Eingang des zweiten Master-Speicherelements LMb' verbunden und zum Anschluss an eine zweite kombinatorische Logikschaltung CLB' bestimmt und vorliegend auch an diese angeschlossen ist. Die erste kombinatorische Logikschaltung CLA' ist schaltungstechnisch identisch mit der zweiten kombinatorischen Logikschaltung CLB'. In dieser Redundanz ist ein hoher Hardware-Aufwand des elektrischen Schaltkreises 100' begründet. Da im vorliegenden Stand der Technik zwei kombinatorische Logikschaltungen CLA', CLB' vorgesehen sind, sind zwei Signaleingänge SA', SB' definiert. Die zwei kombinatorischen Logikschaltungen CLA', CLB' sind vorliegend nicht vom elektrischen Schaltkreis 100' umfasst.

Der elektrischer Schaltkreises 100' weist ferner ein erstes Ausgangsauswahlelement CSa' auf, das eingangsseitig mit je einem Ausgang der Slave-Speicherelemente LSa', LSb' verbunden ist. Der elektrischer Schaltkreises 100' weist ebenfalls ein zweites Ausgangsauswahlelement CSb' auf, das eingangsseitig mit je einem Ausgang der Slave-Speicherelemente LSa', LSb' verbunden ist. Ebenfalls der Fig. 1 entnehmbar sind zwei vom elektrischen Schaltkreises 100' umfasste Zwischenauswahlelemente CMa', CMb', die eingangsseitig mit je einem Ausgang beider Master-Speicherelemente LMa', LMb' verbunden sind. Die Zwischenauswahlelemente CMa', CMb' sind ausgangsseitig mit verschiedenen der Slave-Speicherelemente LSa', LSb' verbunden. Dem Master-Slave-Speicher LMa', LSa', LMb', LSb' ist ein Speichertaktsignal CLK_S' mit einer gemeinsamen Speichertaktfrequenz z.B. 400 MHz zuführbar.

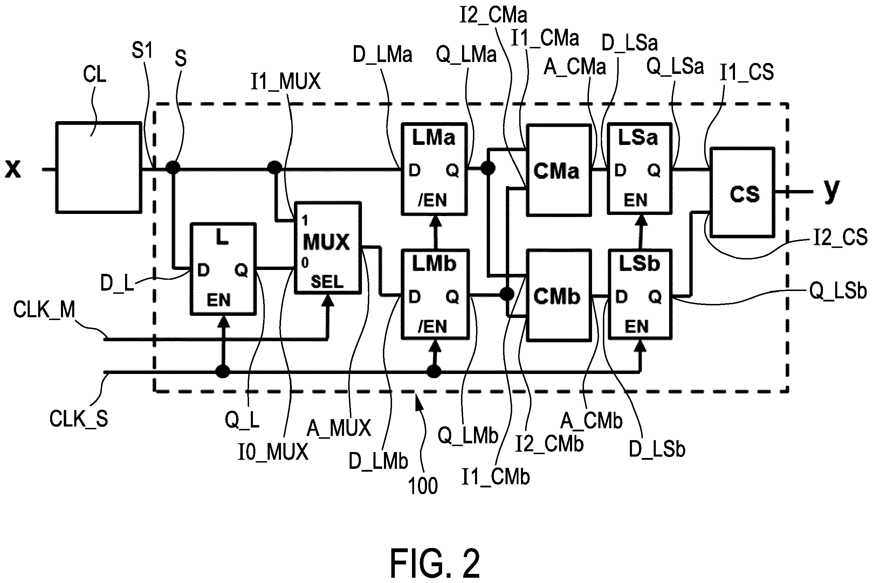

Ein erfindungsgemäßer elektrischer Schaltkreis 100 wird nun mit Bezug auf Fig. 2 beschrieben. Im vorliegenden Beispiel ist der elektrische Schaltkreis 100 durch ein mit gestrichelten Linien ausgeführtes Rechteck umrandet. Der elektrische Schaltkreis 100 weist zwei redundante Master-Slave-Speicher LMa, LSa, LMb, LSb auf. Die redundanten Master-Slave-Speicher LMa, LSa, LMb, LSb weisen jeweils ein Master-Speicherelement LMa, LMb und ein Slave-Speicherelement LSa, LSb auf. Vorliegend sind die Speicherelemente LMa, LSa, LMb, LSb, als D-Latches ausgebildet. Der elektrische Schaltkreis 100 weist einen Signaleingang S auf, der mit einem Eingang D_LMa des ersten Master-Speicherelements LMa verbunden und zum Anschluss an eine kombinatorische Logikschaltung CL bestimmt und vorliegend auch an diese angeschlossen ist. Die kombinatorische Logikschaltung CL ist im vorliegenden Ausführungsbeispiel nicht vom Schaltkreis 100 umfasst, d.h. außerhalb des mit gestrichelten Linien ausgeführten Rechtecks dargestellt. Alternativ kann die kombinatorische Logikschaltung CL vom Schaltkreis 100 umfasst sein. Da nur genau eine kombinatorische Logikschaltung CL erforderlich ist, ist der Schaltkreis 100 also bezüglich der angeschlossenen kombinatorischen Logikschaltung CL redundanzfrei betreibbar. Da im vorliegenden Ausführungsbeispiel nur eine kombinatorische Logikschaltung CL vorgesehen ist, ist auch nur ein Signaleingang S definiert. Der Hardware-Aufwand zum Betrieb des elektrischen Schaltkreises 100 der Fig. 2 ist geringer als der des Standes der Technik gezeigt in Fig.1.

Der elektrische Schaltkreis 100 in Fig. 2 weist ferner genau ein Ausgangsauswahlelement CS auf, das eingangsseitig über seine Eingänge I1_CS, I2_CS mit je einem Ausgang Q_LSa, Q_LSb der Slave-Speicherelemente LSa, LSb verbunden ist, wobei der erste Eingang I1_CS mit dem Ausgang Q_LSa des ersten Slave-Speicherelements LSa und der zweite Eingang I2_CS mit dem Ausgang Q_LSb des zweiten Slave-Speicherelements LSb verbunden ist. Das Ausgangsauswahlelement CS ist vorliegend als Muller-C-Element ausgebildet, das bei ungleichen Eingangssignalen seinen vorherigen Ausgangswert hält und wie die kombinatorische Logikschaltung CL nicht redundant ausgeführt werden muss. Durch die zwei redundanten Master-Slave-Speicher LMa, LSa, LMb, LSb und das Ausgangsauswahlelement CS ist bereits ein SEU-Schutz im Sinne einer DMR realisiert.

Ebenfalls der Fig. 2 entnehmbar sind zwei vom elektrischen Schaltkreis 100 umfasste Zwischenauswahlelemente CMa, CMb, die eingangsseitig über ihre Eingänge I1_CMa, I2_CMa, I1_CMb, I2_CMb, mit je einem Ausgang Q_LMa, Q_LMb beider Master-Speicherelemente LMa, LMb verbunden sind. Der erste Eingang I1_CMa des ersten Zwischenauswahlelements CMa ist mit dem zweiten Eingang I2_CMb des zweiten Zwischenauswahlelements CMb und dem Ausgang Q_LMa des ersten Master-Speicherelements LMa verbunden. Der zweite Eingang I2_CMa des ersten Zwischenauswahlelements CMa ist mit dem ersten Eingang I1_CMb des zweiten Zwischenauswahlelements CMb und dem Ausgang Q_LMb des zweiten Master-Speicherelements LMb verbunden. Der erste Eingang I1_CMa des ersten Zwischenauswahlelements CMa ist mit dem ersten Eingang I1_CMb des zweiten Zwischenauswahlelements CMb verbunden. Der zweite Eingang I2_CMa des ersten Zwischenauswahlelements CMa ist mit dem zweiten Eingang I2_CMb des zweiten Zwischenauswahlelements CMb verbunden.

Die Zwischenauswahlelemente CMa, CMb sind ausgangsseitig ausschließlich mit verschiedenen der Slave-Speicherelemente LSa, LSb verbunden. Dabei ist der Ausgang A_CMa des ersten Zwischenauswahlelements CMa nur mit dem Eingang D_LSa des ersten Slave-Speicherelemente LSa verbunden. Der Ausgang A_CMb des zweiten Zwischenauswahlelements CMb ist nur mit dem Eingang D_LSb des zweiten Slave-Speicherelements LSa verbunden. Die Zwischenauswahlelemente CMa, CMb sind vorliegend als Muller-C-Elemente ausgebildet, die bei ungleichen Eingangssignalen ihren vorherigen Ausganswert halten. Die Zwischenauswahlelemente CMa, CMb dienen dem Auswählen und Speichern gleicher Eingangssignale. Das zweite Zwischenauswahlelement CMb dient ausschließlich dazu, die Eingänge der Slave-Speicherelemente LSa, LSb getrennt zu halten und somit gleichzeitige Störungen beider redundanter Zweige zu verhindern.

Der elektrische Schaltkreis 100 weist weiter einen Multiplexer MUX mit einem ersten Eingang I1_MUX, einem zweitem Eingang I2_MUX und einem Ausgang A_MUX auf. Der elektrische Schaltkreis 100 weist ferner ein Eingangsspeicherelement L auf, das eingangsseitig über seinen Eingang D_L mit dem Signaleingang S und dementsprechend eingangsseitig auch mit der kombinatorische Logikschaltung CL verbunden ist. Auch der Multiplexer MUX ist über seinen ersten Eingang I1_MUX mit dem Signaleingang S und dementsprechend eingangsseitig auch mit der kombinatorische Logikschaltung CL verbunden. Die kombinatorische Logikschaltung CL wird mit einem Eingangssignalvektor x beaufschlagt. Vorliegend ist das Eingangsspeicherelement L als D-Latch ausgebildet.

Der Multiplexer MUX ist weiterhin über seinen zweiten Eingang I2_MUX eingangsseitig mit einem Ausgang Q_L des Eingangsspeicherelements L und ausgangsseitig mit einem Eingang D_LMb des zweiten Master-Speicherelementes LMb verbunden. Erfindungsgemäß kann ein Duplizieren der vorgeschalteten kombinatorischen Logikschaltung CL, beziehungsweise das Einfügen starrer Verzögerungselemente, dadurch vermieden werden, dass für den SET-Schutz das besagte Eingangsspeicherelement L und der Multiplexer MUX vorgesehen sind.

Dem Master-Slave-Speicher LMa, LSa, LMb, LSb und dem Eingangsspeicherelement L ist über jeweilige Takteingänge EN, /EN ein Speichertaktsignal CLK_S mit einer gemeinsamen Speichertaktfrequenz zuführbar. Dem Multiplexer MUX ist über seinen Umschalteingang SEL ein Umschalttaktsignal CLK_M mit einer Umschalttaktfrequenz zum eingangsseitigen Umschalten des Multiplexers MUX zuführbar ist. Das Speichertaktsignal CLK_S und das Umschalttaktsignal CLK_M sind über separate Takteingänge in den elektrischen Schaltkreis 100 geführt. Der elektrische Schaltkreis 100 ist zeitgliedfrei ausgebildet, d.h. ohne eigenes festes Zeitglied.

Im vorliegenden Ausführungsbeispiel ist der Schaltkreis 100 auf eine Speichertaktfrequenz von 400 MHz ausgelegt, d.h. das anzulegende Speichertaktsignal CLK_S kann eine Frequenz bis zu 400 MHz aufweisen. Der Schaltkreis 100 ist auf eine Umschalttaktfrequenz von 400 MHz ausgelegt, d.h. das anzulegende Umschalttaktsignals CLK_M kann eine Frequenz bis zu 400 MHz aufweisen. Wie weiter unten bezüglich des Betriebsverfahrens ausgeführt wird, ist die Speichertaktfrequenz im Fehlerkorrekturmodus geringer als die Umschalttaktfrequenz, bevorzugt halb so groß. Der auf die Speichertaktfrequenz von 400 MHz ausgelegte Schaltkreis 100 würde demnach im Fehlerkorrekturmodus nur mit 200 MHz Speichertaktfrequenz über das Speichertaktsignal CLK_S angesteuert.

Zwar reizt der Schaltkreis 100 im Fehlerkorrekturmodus nicht seine maximale Performance aus, d.h. im vorliegenden Fall nur 50% seiner maximalen Performance. Allerdings weist der in Fig. 2 dargestellte Schaltkreis 100 gegenüber dem in Fig. 1 dargestellten Schaltkreis 100' des Standes der Technik einen geringeren Hardware-Aufwand auf, wenn man davon ausgeht, dass der Hardware-Aufwand von kombinatorischer Logik im Vergleich zu Speicherelementen deutlich höher ist.

Der vorliegende elektrische Schaltkreis 100 weist mit seiner Auslegungs-UmschalttaktFrequenz von 400 MHz eine Periodenlänge des Umschalttaktsignals CLK_M von 2.5 ns auf. Diese ist wenigstens zweimal so lang ist wie eine angenommene maximale Störimpulsdauer von 1 ns, die zu einem Soft-Error führen kann. Eine angenommene maximale Störimpulsdauer von 1 ns kann zu einem Soft-Error führen, wenn keine Schutzschaltung gegen Soft-Errors vorgesehen ist.

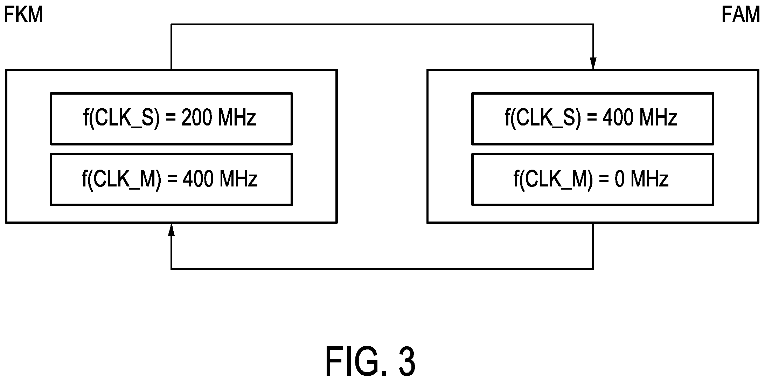

Eine vereinfachte Darstellung eines ersten Ausführungsbeispiels eines erfindungsgemäßen Betriebsverfahrens ist in Fig. 3 dargestellt. Das Betriebsverfahren ist zum Betreiben des mit Bezug auf Fig. 2 beschriebenen elektrischen Schaltkreises geeignet. Das Betriebsverfahren weist einen Fehlerkorrekturmodus FKM zur Soft-Error-Korrektur auf. Im Fehlerkorrekturmodus FKM erfolgt ein Ansteuern der Master-Slave-Speicher und des Eingangsspeicherelements über das Speichertaktsignal CLK_S mit einer gemeinsamen Speichertaktfrequenz von 200 MHz. Ein Ansteuern des Multiplexers erfolgt über das Umschalttaktsignal CLK_M mit einer Umschalttaktfrequenz von 400 MHz. Die Umschalttaktfrequenz ist doppelt so hoch wie die Speichertaktfrequenz, wobei Speichertaktfrequenz und Umschalttaktfrequenz phasensynchronisiert sind. Für eine angenommene maximale Störimpulsdauer von 1 ns ist die Umschalttaktfrequenz mit 400 MHz (2.5 ns Periodenlänge) hinreichend niedrig.

Das Betriebsverfahren in Fig. 3 umfasst ebenfalls einen Fehlerkorrektur-Abschaltmodus FAM, auf den umgeschaltet werden kann, wenn in einem angenommenen Anwendungsszenario kein SET-Schutz erforderlich ist. Im Fehlerkorrektur-Abschaltmodus FAM erfolgt ein Ansteuern der Master-Slave-Speicher und des Eingangsspeicherelements über das Speichertaktsignal CLK_S mit einer gemeinsamen Speichertaktfrequenz von insbesondere bis zu 400 MHz. Dies ist möglich, da der mit Bezug auf Fig. 2 beschrieben elektrische Schaltkreis auf eine gemeinsamen Speichertaktfrequenz von insbesondere bis zu 400 MHz ausgelegt ist. Ein Ansteuern des Multiplexers erfolgt über das Umschalttaktsignal CLK_M mit einer Umschalttaktfrequenz vom 0 MHz, wobei das Umschalttaktsignal CLK_M auf statischem High-Pegel liegt und der Signaleingang S mittels des Multiplexers MUX auf den Eingang D_LMb des zweiten Master-Speicherelements LMb durchgeschaltet ist.

Wenn eine Soft-Error-Korrektur erforderlich ist, kann vom Fehlerkorrektur-Abschaltmodus FAM auf den Fehlerkorrekturmodus FKM zurückgeschalten werden.

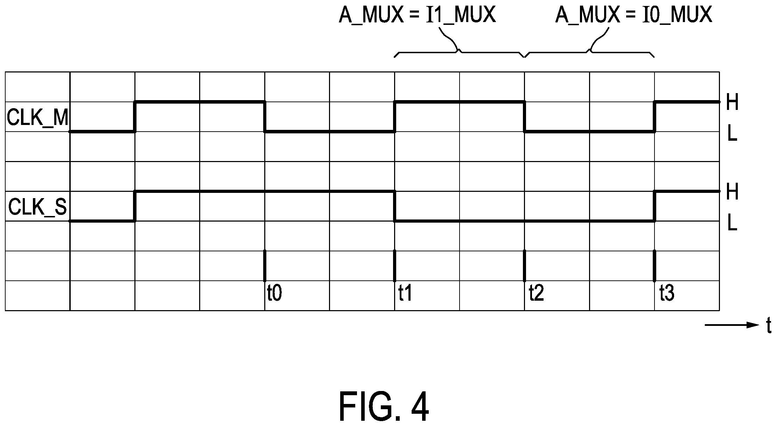

Im Folgenden wird das Betriebsverfahren mit Bezug auf das Taktdiagramm der Fig. 4 unter Bezugnahme auf den elektrischen Schaltkreis der Fig. 2 eingehender erläutert. In Fig. 4 gezeigt sind ein Umschalttaktsignal CLK_M und ein Speichertaktsignal CLK_S, jeweils in Form eines periodischen Rechtecksignals abgetragen über der Zeit t. High-Pegel H und Low-Pegel L sind ebenfalls dargestellt. Die Umschalttaktfrequenz ist doppelt so hoch wie die Speichertaktfrequenz, d.h. die Periodenlänge des Umschalttaktsignals CLK_M ist halb so groß wie die Periodenlänge des Speichertaktsignals CLK_S. Speichertaktfrequenz und Umschalttaktfrequenz sind phasensynchronisiert. Wie bereits erwähnt arbeitet der elektrische Schaltkreis im vorliegenden Ausführungsbeispiel nur mit einer Speichertaktfrequenz, die der halben Umschalttaktfrequenz entspricht, d.h. insbesondere mit einem einfachen Teiler aus der Umschalttaktfrequenz erzeugt werden kann.

Das Eingangsspeicherelement L speichert das an seinem Eingang D_L anliegende Signal S1 während der Low-Phase vom Speichertaktsignal CLK_S an seinem Ausgang Q_L, d. h. die Verzögerungszeit der kombinatorischen Logikschaltung CL muss schon vor der High-Low-Flanke des Speichertaktsignals CLK_S beendet sein. Die Eingänge I1_MUX, I2_MUX des Multiplexers MUX werden mit dem schnellen Umschalttaktsignal CLK_M inmitten der Low-Phase des Speichertaktsignals CLK_S umgeschaltet.

Da sich die Master-Speicherelemente LMa, LMb während der High-Phase des Speichertaktsignals CLK_S im Speichermodus befinden, d.h. Eingangsänderungen unwirksam sind, braucht diese Phase für den SET-Schutz nicht weiter berücksichtigt werden. Während der ersten Hälfte der Low-Phase des Speichertaktsignals CLK_S (d.h. zwischen t1 und t2) schaltet der Multiplexer MUX den von der kombinatorischen Logikschaltung CL ausgegebenen Wert S auf den Eingang D_LMb des redundanten (zweiten) Master-Speicherelements LMb, so dass die Zwischenauswahlelemente CMa, CMb durch die transparent geschalteten Master-Speicherelemente LMa, LMb immer gleiche Eingangssignale erhalten, die sie auch entsprechend speichern. Während der zweiten Hälfte der Low-Phase des Speichertaktsignals CLK_S (d.h. zwischen t2 und t3) schaltet der Multiplexer MUX das Ausgangssignal Q_L des Eingangsspeicherelements L auf den Eingang D_LMb des redundanten (zweiten) Master-Speicherelements LMb.

Ein SET-Störimpuls während dieser Zeit kann entweder zum Zeitpunkt t1, zum Zeitpunkt t2, zum Zeitpunkt t3 oder zwischen diesen Zeitpunkten auftreten. Mit einer angenommenen maximalen Störimpulsdauer von 1ns ist ein SET-Störimpuls kurz genug, um nicht zu zwei Zeitpunkten t1 und t2 oder t2 und t3 gleichzeitig wirksam werden zu können. Damit ergeben sich für diesen Zeitraum drei Fälle:
Im ersten Fall F1 tritt ein SET-Störimpuls um den Zeitpunkt t1 auf, so dass das Eingangsspeicherelement L einen falschen Wert speichert. Allerdings weisen der erste Eingang I1_MUX des Multiplexers MUX, die Eingänge D_LMa, D_LMb der Master-Speicherelemente LMa, LMb sowie die Eingänge I1_CMa, I12_CMa, I1_CMb, I2_CMb der Zwischenauswahlelemente CMa, CMb noch vor dem Zeitpunkt t2 den richtigen Wert auf, so dass die Zwischenauswahlelemente CMa, CMb den richtigen Wert speichern können. Nach dem Zeitpunkt t2 wird zwar der Eingang D_LMb des Master-Speicherelementes LMb auf den Ausgang Q_L des Eingangsspeicherelements L, das den falschen Wert hält, geschaltet. Dies hat aber keinen Einfluss mehr auf die Zwischenauswahlelemente CMa, CMb.

Im zweiten Fall F2 tritt ein SET-Störimpuls um den Zeitpunkt t2 auf, so dass das Eingangsspeicherelement L zwar den richtigen Wert speichert, der erste Eingang I1_MUX des Multiplexers MUX, die Eingänge D_LMa, D_LMb der Master-Speicherelemente LMa, LMb sowie die Eingänge I1_CMa, I2_CMa, I1_CMb, I2_CMb der Zwischenauswahlelemente CMa, CMb aber aufgrund des SET-Störimpulses den falschen Wert erhalten. Nach dem Zeitpunkt t2 wird der Eingang D_LMb des Master-Speicherelementes LMb auf den Ausgang Q_L des Eingangsspeicherelements L, das den richtigen Wert hält, geschaltet. Vor dem Zeitpunkt t3 (nach dem SET-Ende) wird schließlich auch der Eingang D_LMa des Master-Speicherelementes LMa korrekt, womit die Zwischenauswahlelemente CMa, CMb den richtigen Wert bekommen.

Im dritten Fall F3 tritt ein SET-Störimpuls um den Zeitpunkt t3 auf, so dass das Eingangsspeicherelement L den richtigen Wert speichert, und bis kurz nach dem Zeitpunkt t2 die Eingänge D_LMa, D_LMb der Master-Speicherelemente LMa, LMb sowie die Eingänge I1_CMa, I2_CMa, I1_CMb, I2_CMb der Zwischenauswahlelemente CMa, CMb den richtigen Wert erhalten. Eine Verfälschung des Eingangs D_LMa des Master-Speicherelementes LMa durch einen SET hat danach keinen Einfluss auf die Zwischenauswahlelemente CMa, CMb mehr.

Alle Fälle F1 bis F3 ergeben jeweils einen richtigen Wert in den Zwischenspeicherelementen CMa, CMb und damit im Ausgangssignal y, das durch das Ausgangsauswahlelement CS des elektrischen Schaltkreises 100 ausgegeben wird. Dies unbeschadet der Tatsache, dass in den Fällen F1 und F3 vorübergehend in einem der Master-Speicherelemente LMa, LMb durch die SETs ausgelöste Speicherfehler auftreten könnten.

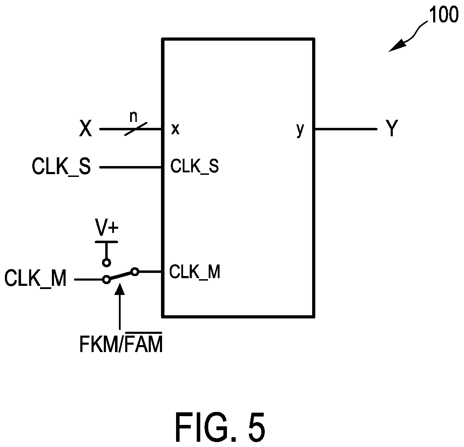

Fig. 5 zeigt eine vereinfachte Darstellung eines erfindungsgemäßen elektrischen Schaltkreises 100 zur Verdeutlichung einer Ansteuermöglichkeit im Rahmen des Betriebsverfahrens. Der Schaltkreis 100 wird mit Eingangssignalvektor x beaufschlagt und ist über das Speichertaktsignal CLK_S angesteuert. Im Fehlerkorrekturmodus FKM wird ein erzeugtes Umschalttaktsignal CLK_M dem Schaltkreis 100 auch zugeführt. Im Fehlerkorrektur-Abschaltmodus FAM wird ein etwaig erzeugtes Umschalttaktsignal CLK_M dem Schaltkreis 100 nicht zugeführt. Im Fehlerkorrektur-Abschaltmodus FAM liegt stattdessen ein statischer High-Pegel V+ am Schaltkreis 100 an.

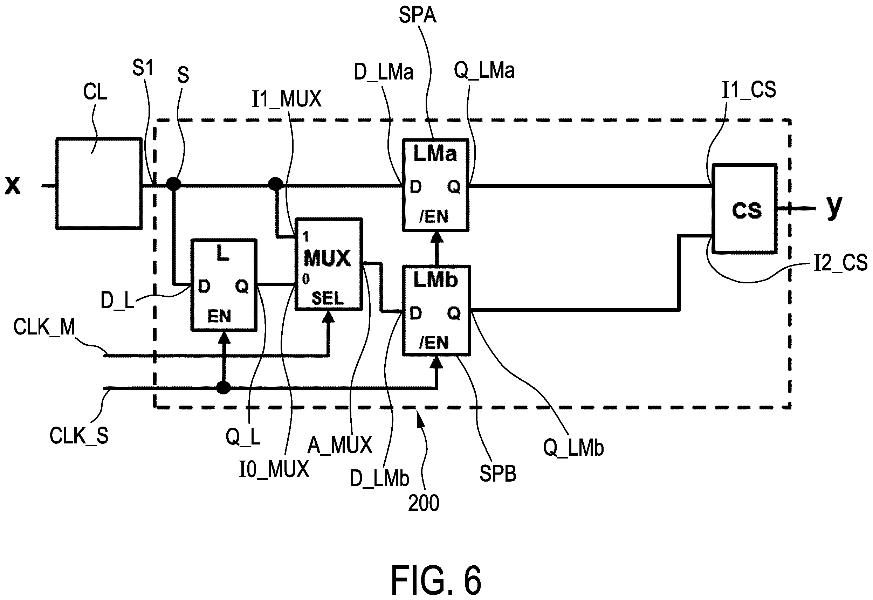

Das Ausführungsbeispiel der Fig. 6, das einen Schaltkreis 200 gemäß des zweiten Aspekts der Erfindung zeigt, entspricht dem mit Bezug auf Fig. 2 beschriebenen Ausführungsbeispiel eines Schaltkreises mit dem Unterschied, dass das Ausführungsbeispiel der Fig. 6 keine Slave-Speicherelemente und keine Ausgangsauswahlelemente aufweist.

Dementsprechend weist der Schaltkreis 200 in Fig. 6 zwei redundante Speicher SPA, SPB auf, die jeweils nur ein Master-Speicherelement LMa, LMb aufweisen. Die Master-Speicherelement LMa, LMb sind D-Latches.

Der elektrische Schaltkreis 100 in Fig. 6 weist genau ein Ausgangsauswahlelement CS auf, das eingangsseitig über seinen ersten Eingang I1_CS mit dem Ausgang Q_LMa des ersten Master-Speicherelements LMa des ersten Speichers SPA verbunden ist. Das Ausgangsauswahlelement CS ist eingangsseitig über seinen zweiten Eingang I2_CS mit dem Ausgang Q_LMb des Master-Speicherelements LMa des redundanten (zweiten) Speichers SPB verbunden ist.

## Patentansprüche

1. Elektrischer Schaltkreis (100) mit
- zwei redundanten Master-Slave-Speichern (LMa, LSa, LMb, LSb), die jeweils ein Master-Speicherelement (LMa, LMb) und ein Slave-Speicherelement (LSa, LSb) aufweisen,
- einem Signaleingang (S), der mit einem Eingang eines (LMa) ersten der Master-Speicherelemente (LMa, LMb) verbunden und zum Anschluss an eine kombinatorische Logikschaltung (CL) bestimmt ist,
- einem Ausgangsauswahlelement (CS), das eingangsseitig jeweils mit einem Ausgang der Slave-Speicherelemente (LSa, LSb) verbunden ist,
**dadurch gekennzeichnet, dass**
- zwei Zwischenauswahlelementen (CMa, CMb), die eingangsseitig jeweils mit einem Ausgang beider Master-Speicherelemente (LMa, LMb) und ausgangsseitig mit verschiedenen der Slave-Speicherelemente (LSa, LSb) verbunden sind,
- der elektrische Schaltkreis einen Multiplexer (MUX) und ein Eingangsspeicherelement (L) aufweist, die eingangsseitig mit dem Signaleingang (S) verbunden sind;
- der Multiplexer (MUX) eingangsseitig mit einem Ausgang des Eingangsspeicherelements (L) und ausgangsseitig mit einem Eingang (LMb) eines zweiten der Master-Speicherelemente (LMa, LMb) verbunden ist;
- den Master-Slave-Speichern (LMa, LSa, LMb, LSb) und dem Eingangsspeicherelement (L) ein Speichertaktsignal (CLK_S) mit einer gemeinsamen Speichertaktfrequenz zuführbar ist; und
- dem Multiplexer (MUX) ein Umschalttaktsignal (CLK_M) mit einer Umschalttaktfrequenz zum eingangsseitigen Umschalten des Multiplexers (MUX) zuführbar ist.

2. Schaltkreis nach einem Anspruch 1, **dadurch gekennzeichnet, dass** das Ausgangsauswahlelement (CS) und die Zwischenauswahlelemente (CMa, CMb) Muller-C-Elemente oder Voter sind, die insbesondere bei ungleichen Eingangssignalen ihren vorherigen Ausgangswert halten.

3. Elektrischer Schaltkreis (200) mit
- zwei redundanten Speichern (SPA, SPB), die jeweils ein Master-Speicherelement (LMa, LMb) aufweisen,
- einem Signaleingang (S), der mit einem Eingang eines (LMa) ersten der Master-Speicherelemente (LMa, LMb) verbunden und zum Anschluss an eine kombinatorische Logikschaltung (CL) bestimmt ist,
- einem Ausgangsauswahlelement (CS), das eingangsseitig jeweils mit einem Ausgang der Master-Speicherelemente (LMa, LMb) verbunden ist,
**dadurch gekennzeichnet, dass**
- der elektrische Schaltkreis einen Multiplexer (MUX) und ein Eingangsspeicherelement (L) aufweist, die eingangsseitig mit dem Signaleingang (S) verbunden sind;
- der Multiplexer (MUX) eingangsseitig mit einem Ausgang des Eingangsspeicherelements (L) und ausgangsseitig mit einem Eingang (LMb) eines zweiten der Master-Speicherelemente (LMa, LMb) verbunden ist;
- den Speichern (SPA, SPB) und dem Eingangsspeicherelement (L) ein Speichertaktsignal (CLK_S) mit einer gemeinsamen Speichertaktfrequenz zuführbar ist; und
- dem Multiplexer (MUX) ein Umschalttaktsignal (CLK_M) mit einer Umschalttaktfrequenz zum eingangsseitigen Umschalten des Multiplexers (MUX) zuführbar ist.

4. Schaltkreis nach einem der vorangehenden Ansprüche, **dadurch gekennzeichnet, dass** die Speicherelemente (LMa, LSa, LMb, LSb, L) D-Latches sind.

5. Schaltkreis nach einem der vorangehenden Ansprüche, **dadurch gekennzeichnet, dass** der Schaltkreis auf eine Umschalttaktfrequenz mit einer Periodenlänge ausgelegt ist, die wenigstens zwei mal so lang ist wie eine angenommene maximale Störimpulsdauer, die zu einem korrigierbaren Soft-Error führen kann.

6. Schaltkreis nach einem der vorangehenden Ansprüche, **dadurch gekennzeichnet, dass** das Speichertaktsignal (CLK_S) und das Umschalttaktsignal (CLK_M) über separate Takteingänge in den elektrischen Schaltkreis geführt sind.

7. Schaltkreis nach einem der vorangehenden Ansprüche, aufweisend eine kombinatorische Logikschaltung (CL), die mit dem Signaleingang verbunden ist.

8. Schaltkreis nach Anspruch 7, **dadurch gekennzeichnet, dass** der Schaltkreis bezüglich der kombinatorischen Logikschaltung (CL) redundanzfrei ausgebildet ist.

9. Schaltkreis nach einem der vorangehenden Ansprüche, ausgebildet als integrierter Schaltkreis.

10. Betriebsverfahren zum Betreiben eines elektrischen Schaltkreises nach einem der vorangehenden Ansprüche, wobei das Betriebsverfahren einen Fehlerkorrekturmodus (FKM) zur Soft-Error-Korrektur aufweist mit den Schritten:
- Ansteuern der Master-Slave-Speicher und des Eingangsspeicherelements mit einer gemeinsamen Speichertaktfrequenz oder Ansteuern der Speicher und des Eingangsspeicherelements mit einer gemeinsamen Speichertaktfrequenz,
- Ansteuern des Multiplexers mit einer Umschalttaktfrequenz, wobei
die Umschalttaktfrequenz höher als die gemeinsame Speichertaktfrequenz ist.

11. Betriebsverfahren nach Anspruch 10, **dadurch gekennzeichnet, dass** die Umschalttaktfrequenz ein ganzzahliges Vielfaches der Speichertaktfrequenz ist.

12. Betriebsverfahren nach Anspruch 10 oder 11, **dadurch gekennzeichnet, dass** die Umschalttaktfrequenz doppelt so hoch wie die Speichertaktfrequenz ist.

13. Betriebsverfahren nach Anspruch 11 oder 12, **dadurch gekennzeichnet, dass** Speichertaktfrequenz und Umschalttaktfrequenz phasensynchronisiert sind.

14. Betriebsverfahren nach einem der Ansprüche 10 bis 13, wobei die Umschalttaktfrequenz eine Periodenlänge aufweist, die wenigstens zwei mal so lang ist wie eine angenommene maximale Störimpulsdauer, die zu einem korrigierbaren Soft-Error führen kann.

15. Betriebsverfahren nach einem der Ansprüche 10 bis 14, wobei das Betriebsverfahren einen Fehlerkorrektur-Abschaltmodus (FAM) aufweist, bei dem die Umschalttaktfrequenz null ist und insbesondere das Umschalttaktsignal auf statischem High-Pegel liegt und/oder der Signaleingang mittels des Multiplexers auf den Eingang des zweiten der Master-Speicherelemente durchgeschaltet ist.

16. Betriebsverfahren nach Anspruch 15, wobei die gemeinsame Speichertaktfrequenz innerhalb des Fehlerkorrektur-Abschaltmodus' doppelt so hoch ist wie außerhalb.

## Claims

1. Electric circuit (100) with
- two redundant master/slave memories (LMa, LSa, LMb, LSb), which each have a master memory element (LMa, LMb) and a slave memory element (LSa, LSb),
- a signal input (S), which is connected to an input of a (LMa) first of the master memory elements (LMa, LMb) and is intended for connection to a combinational logic circuit (CL),
- an output selection element (CS), which is connected on the input side respectively to an output of the slave memory elements (LSa, LSb),
**characterised in that**
- two intermediate selection elements (CMa, CMb), which are connected on the input side respectively to an output of both master memory elements (LMa, LMb) and on the output side to different slave memory elements (LSa, LSb),
- the electric circuit has a multiplexer (MUX) and an input memory element (L), which are connected on the input side to the signal input (S);
- the multiplexer (MUX) is connected on the input side to an output of the input memory element (L) and on the output side to an input (LMb) of a second of the master memory elements (LMa, LMb);
- a memory clock signal (CLK_S) with a common memory clock frequency can be supplied to the master slave memories (LMa, LSa, LMb, LSb) and the input memory element (L); and
- a switching clock signal (CLK_M) with a switching clock frequency for the input-side switching of the multiplexer (MUX) can be supplied to the multiplexer (MUX).

2. Circuit according to claim 1, **characterised in that** the output selection element (CS) and the intermediate selection elements (CMa, CMb) are Muller C elements or voters, which retain their previous output value, in particular with uneven input signals.

3. Electric Circuit (200) with
- two redundant memories (SPA, SPB), which each have a master memory element (LMa, LMb),
- a signal input (S), which is connected to an input of a (LMa) first of the master memory elements (LMa, LMb) and is intended for connection to a combinational logic circuit (CL),
- an output selection element (CS), which is connected on the input-side respectively to an output of the master memory elements (LMa, LMb),
**characterised in that**
- the electric circuit has a multiplexer (MUX) and an input memory element (L), which are connected on the input side to the signal input (S);
- the multiplexer (MUX) is connected on the input side to an output of the input memory element (L) and on the output side to an input (LMb) of a second of the master-memory elements (LMa, LMb);
- a memory clock signal (CLK_S) with a common memory clock frequency can be supplied to the memories (SPA, SPB) and the input memory element (L); and
- a switching clock signal (CLK_M) with a switching clock frequency for the input-side switching of the multiplexer (MUX) can be supplied to the multiplexer (MUX).

4. Circuit according to any one of the preceding claims, **characterised in that** the memory elements (LMa, LSa, LMb, LSb, L) are D-latches.

5. Circuit according to any one of the preceding claims, **characterised in that** the circuit is configured to have a switching clock frequency with a period length, which is at least twice as long as an adopted maximum interference pulse duration, which can result in a correctable soft error.

6. Circuit according to any one of the preceding claims, **characterised in that** the memory clock signal (CLK_S) and the switching clock signal (CLK_M) are routed via separate clock inputs into the electric circuit.

7. Circuit according to any one of the preceding claims, having a combinational logic circuit (CL), which is connected to the signal input.

8. Circuit according to claim 7, **characterised in that** the circuit is designed to be redundancy-free relative to the combinational logic circuit (CL).

9. Circuit according to any one of the preceding claims, designed as an integrated circuit.

10. Operating method for operating an electric circuit according to any one of the preceding claims, wherein the operating method has an error correction mode (FKM) for soft error correction with the steps:
- controlling the master slave memory and the input memory element with a common memory clock frequency or controlling the memory and the input memory element with a common memory clock frequency,
- controlling the multiplexer with a switching clock frequency, wherein
the switching clock frequency is higher than the common memory clock frequency.

11. Operating method according to claim 10, **characterised in that** the switching clock frequency is an integral multiple of the memory clock frequency.

12. Operating method according to claim 10 or 11, **characterised in that** the switching clock frequency is twice as high as the memory clock frequency.

13. Operating method according to claim 11 or 12, **characterised in that** the memory clock frequency and switching clock frequency are phase-synchronised.

14. Operating method according to any of claims 10 to 13, wherein the switching clock frequency has a period length, which is at least twice as long as an adopted maximum interference pulse duration which can lead to a correctable soft error.

15. Operating method according to any of claims 10 to 14, wherein the operating method has an error correction shutdown mode (FAM), in which the switching clock frequency is zero and in particular the switching clock signal is at a static high-level and/or the signal input is connected by means of the multiplexer to the input of the second of the master memory elements.

16. Operating method according to claim 15, wherein the common memory clock frequency inside the error correction shutdown mode is twice as high as outside.

## Revendications

1. Circuit électrique (100) avec
- deux mémoires maître-esclave redondantes (LMa, LSa, LMb, LSb) qui comprennent chacune un élément de mémoire maître (LMa, LMb) et un élément de mémoire esclave (LSa, LSb),
- une entrée de signaux (S) qui est reliée avec une entrée d'un premier (LMa) des éléments de mémoire maîtres (LMa, LMb) et qui est conçue pour le raccordement à un circuit logique combinatoire (CL),
- un élément de sélection de sortie (CS) qui est relié côté entrée avec une sortie des éléments de mémoire esclave (LSa, LSb),
**caractérisé en ce que**
- deux éléments de sélection intermédiaires (CMa, CMb), qui sont reliés côté entrée chacun avec une sortie des deux éléments de mémoires maîtres (LMa, LMb) et côté sortie avec différents éléments de mémoires esclaves (LSa, LSb),
- le circuit électrique comprend un multiplexeur (MUX) et un élément de mémoire d'entrée (L), qui sont reliés côté entrée avec l'entrée de signaux (S);
- le multiplexeur (MUX) est relié côté entrée avec une sortie de l'élément de mémoire d'entrée (L) et côté sortie avec une entrée (LMb) d'un deuxième élément de mémoire maître (LMa), LMb) ;
- aux mémoires maître-esclave (LMa, LSa, LMb, LSb) et à l'élément de mémoire d'entrée (L) peut être appliqué un signal de cadencement de mémoire (CLK_S) avec une fréquence de cadencement de mémoire commune ; et
- au multiplexeur (MUX) peut être appliqué un signal de cadencement de commutation (CLK_M) avec une fréquence de cadencement de commutation pour la commutation côté entrée du multiplexeur (MUX).

2. Circuit selon la revendication 1, **caractérisé en ce que** l'élément de sélection de sortie (CS) et les éléments de sélection intermédiaires (CMa, CMb) sont des éléments Muller C ou des voteurs, qui maintiennent leur valeur de départ précédente plus particulièrement dans le cas de signaux d'entrée différents.

3. Circuit électrique (200) avec
- deux mémoires redondantes (SPA, SPB) qui comprennent chacune un élément de mémoire maître (LMa, LMb),
- une entrée de signaux (S), qui est reliée avec une entrée d'un premier (LMa) des éléments de mémoire maîtres (LMa, LMb) et qui est conçue pour le raccordement à un circuit logique combinatoire (CL),
- un élément de sélection de sortie (CS) qui est relié côté entrée à une sortie des éléments de mémoire maîtres (LMa, LMb),
**caractérisé en ce que**
- le circuit électrique comprend un multiplexeur (MUX) et un élément de mémoire d'entrée (L), qui sont reliés côté entrée avec l'entrée de signaux (S) ;
- le multiplexeur (MUX) est relié côté entrée avec une sortie de l'élément de mémoire d'entrée (L) et côté sortie avec une entrée (LMb) d'un deuxième des éléments de mémoire maîtres (LMa, LMb) ;
- aux mémoires (SPA, SPB) et à l'élément de mémoire d'entrée (L) peut être appliqué un signal de cadencement de mémoire (CLK_S) avec une fréquence de cadencement de mémoire commune ; et
- au multiplexeur (MUX) peut être appliqué un signal de cadencement de commutation (CLK_M) avec une fréquence de cadencement de commutation pour la commutation côté entrée du multiplexeur (MUX).

4. Circuit selon l'une des revendications précédentes, **caractérisé en ce que** les éléments de mémoire (LMa, LSa, LMb, LSb, L) sont des bascules D.

5. Circuit selon l'une des revendications précédentes, **caractérisé en ce que** le circuit est conçu pour une fréquence de cadencement de commutation avec une longueur de période qui est au moins deux fois supérieure à une durée d'impulsion parasite maximale supposée, qui peut provoquer une erreur logicielle corrigible.

6. Circuit selon l'une des revendications précédentes, **caractérisé en ce que** le signal de cadencement de mémoire (CLK_S) et le signal de cadencement de commutation CLK_M) sont introduites dans le circuit électrique par des entrées de cadencement séparées.

7. Circuit selon l'une des revendications précédentes, comprenant un circuit logique combinatoire (CL) qui est relié avec l'entrée de signaux.

8. Circuit selon la revendication 7, **caractérisé en ce que** le circuit est conçu sans redondance en ce qui concerne le circuit logique combinatoire (CL).

9. Circuit selon l'une des revendications précédentes, conçu comme un circuit intégré.

10. Procédé d'exploitation pour l'exploitation d'un circuit électrique selon l'une des revendications précédentes, le procédé d'exploitation comprenant un mode de correction d'erreurs (FKM) pour la correction d'erreurs logicielles, avec les étapes suivantes :
- pilotage des mémoires maître-esclave et de l'élément de mémoire d'entrée avec une fréquence de cadencement de mémoire commune ou pilotage des mémoires et de l'élément de mémoire d'entrée avec une fréquence de cadencement de mémoire commune,
- pilotage du multiplexeur avec une fréquence de cadencement de commutation,
la fréquence de cadencement de commutation étant supérieure à la fréquence de cadencement de mémoire commune.

11. Procédé d'exploitation selon la revendication 10, **caractérisé en ce que** la fréquence de cadencement de commutation est multiple entier de la fréquence de cadencement de mémoire.

12. Procédé d'exploitation selon la revendication 10 ou 11, **caractérisé en ce que** la fréquence de cadencement de commutation est le double de la fréquence de cadencement de mémoire.

13. Procédé d'exploitation selon la revendication 11 ou 12, **caractérisé en ce que** la fréquence de cadencement de mémoire et la fréquence de cadencement de commutation sont synchronisées en phase.

14. Procédé d'exploitation selon l'une des revendications 10 à 13, la fréquence de cadencement de commutation présente une longueur de période qui est au moins le double d'une durée d'impulsion parasite maximale supposée qui peut provoquer une erreur logicielle corrigible.

15. Procédé d'exploitation selon l'une des revendications 10 à 14, le procédé d'exploitation comprenant un mode d'arrêt de correction d'erreur (FAM), dans lequel la fréquence de cadencement de commutation est nulle et plus particulièrement le signal de commutation se trouve à un niveau statique haut et/ou l'entrée de signaux est connectée au moyen du multiplexeur à l'entrée du deuxième des éléments de mémoire maîtres.

16. Procédé d'exploitation selon la revendication 15, la fréquence de cadencement de mémoire commune à l'intérieur du mode d'arrêt de correction d'erreur étant deux fois plus élevée qu'à l'extérieur.
